(19) Europäisches Patentamt
European Patent Office
Office européen des brevets

(11) **EP 4 462 605 B1**

(12) **EUROPEAN PATENT SPECIFICATION**

(45) Date of publication and mention
of the grant of the patent:
**14.05.2025 Bulletin 2025/20**

(21) Application number: **24166128.9**

(22) Date of filing: **26.03.2024**

(51) International Patent Classification (IPC):
*H01R 12/59* (2011.01)     *H01R 12/77* (2011.01)

(52) Cooperative Patent Classification (CPC):
**H01R 12/592; H01R 12/69; H01R 12/7017;**
**H05K 1/189;** H01R 12/777; H05K 2201/10189

(54) **CONNECTOR**

VERBINDER

CONNECTEUR

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **11.05.2023 JP 2023078366**

(43) Date of publication of application:
**13.11.2024 Bulletin 2024/46**

(73) Proprietor: **Japan Aviation Electronics Industry,**
**Limited**
**Tokyo 150-0043 (JP)**

(72) Inventor: **NAKAMURA, Keisuke**
**Tokyo, 150-0043 (JP)**

(74) Representative: **Qip Patentanwälte**
**Dr. Kuehn & Partner mbB**
**Bavariaring 10**
**80336 München (DE)**

(56) References cited:
**JP-A- 2018 129 244**     **US-A1- 2020 366 011**

**Description**

BACKGROUND OF THE INVENTION

The present invention relates to a connector, particularly to a connector that is connected to a sheet type connection object having a conductor exposed on at least one surface of the connection object.

In recent years, attention has been drawn to so-called smart clothes that can obtain user's biological data such as the heart rate and the body temperature only by being worn by the user. Such smart clothes have an electrode disposed at a measurement site, and when a wearable device serving as a measurement device is electrically connected to the electrode, biological data can be transmitted to the wearable device.

The electrode and the wearable device can be interconnected by, for instance, use of a connector connected to a conductor drawn from the electrode.

As a connector of this type, for example, JP 2018-129244 A discloses a connector as shown in FIG. 39. This connector includes a housing 2 and a base member 3 that are separately disposed on opposite sides of a flexible substrate 1 to sandwich the flexible substrate 1. Tubular portions 4A of contacts 4 are passed through contact through-holes 2A of the housing 2, and flanges 4B of the contacts 4 are sandwiched between the housing 2 and conductors 1A exposed on the top surface of the flexible substrate 1.

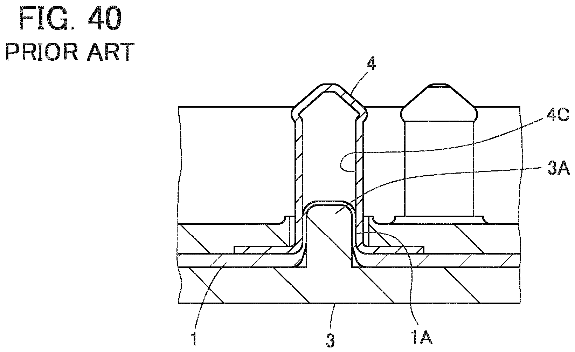

In this state, by pushing the base member 3 toward the housing 2, as shown in FIG. 40, a projection 3A of the base member 3 is inserted into a projection accommodating portion 4C of the contact 4 with the flexible substrate 1 being sandwiched therebetween, and an inner surface of the projection accommodating portion 4C makes contact with the conductor 1A with a predetermined contact force, whereby the contact 4 is electrically connected to the conductor 1A.

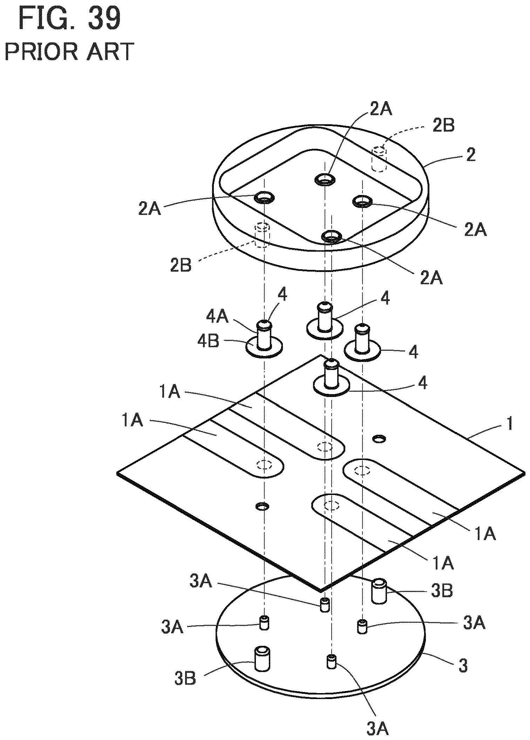

Further, housing fixing posts 3B formed to project from the base member 3 are press-fitted into post accommodating portions 2B of the housing 2 as shown in FIG. 39, so that the housing 2 and the base member 3 are fixed to each other.

When a wearable device is fitted with the connector disclosed in JP 2018-129244 A, the wearable device can be connected to an electrode formed of a conductor.

However, when the conductor 1A is exposed on the bottom surface of the flexible substrate 1, the connector of JP 2018-129244A is useless for electrically connecting the conductor 1A to the contact 4, disadvantageously.

SUMMARY OF THE INVENTION

The present invention has been made to solve the foregoing problem and aims at providing a connector that enables an electrical connection of a contact to a conductor of a connection object regardless of whether the conductor is exposed on the top surface or the bottom surface of the connection object.

A connector according to the present invention comprises:

a plug contact having conductivity and including a tubular portion and a flange, the tubular portion extending along a fitting axis and being provided in its interior with a recessed portion, and the flange extending from a base end of the tubular portion in a direction orthogonal to the fitting axis;
an inner contact having conductivity and being supported while having part of the inner contact inserted in the recessed portion; and
a housing retaining the plug contact,
wherein the housing includes a restriction portion that is disposed in the recessed portion of the plug contact and is configured to restrict rotation of the inner contact,
the inner contact includes

a first contacting portion that makes contact with an inner surface of the recessed portion to be electrically connected to the plug contact,
a second contacting portion that makes contact with the inner surface of the recessed portion on an opposite side from the first contacting portion across the fitting axis and at a position closer to the base end of the recessed portion than the first contacting portion is,
a third contacting portion extending in a direction orthogonal to the fitting axis and facing the flange, and
a restricted portion that faces in an opposite direction from the second contacting portion and makes contact with the restriction portion at a position closer to the base end of the recessed portion than the second contacting portion is, and

part of a connection object of sheet shape having a conductor exposed on at least one surface of the connection object is sandwiched between a bottom surface of the flange of the plug contact and the third contacting portion of the inner contact in a direction along the fitting axis, the bottom surface of the flange makes contact with a top surface of the connection object, and the third contacting portion makes contact with a bottom surface of the connection object, whereby the plug contact is electrically connected to the conductor directly when the conductor is exposed on the top surface of the connection object, and the plug contact is electrically connected to the conductor via the inner contact when the conductor is exposed on the bottom surface of the connection object.

BRIEF DESCRIPTION OF THE DRAWINGS

FIG. 1 is a perspective view showing a connector according to Embodiment 1 connected to a connection object.

FIG. 2 is an exploded perspective view of the connector according to Embodiment 1.

FIG. 3 is a perspective view showing a top insulator used in the connector of Embodiment 1.

FIG. 4 is a perspective view showing a bottom insulator used in the connector of Embodiment 1.

FIG. 5 is a perspective view showing a projection formed in the bottom insulator in Embodiment 1.

FIG. 6 is a plan view showing the projection formed in the bottom insulator in Embodiment 1.

FIG. 7 is a cross-sectional view taken along line A-A in FIG. 6.

FIG. 8 is a partial cross-sectional view showing an inner contact accommodating groove of the projection formed in the bottom insulator in Embodiment 1.

FIG. 9 is a perspective view showing a plug contact used in the connector of Embodiment 1.

FIG. 10 is a cross-sectional view showing the plug contact used in the connector of Embodiment 1.

FIG. 11 is a perspective view of a connection object to be connected to the connector of Embodiment 1, as viewed from an obliquely upper position.

FIG. 12 is a perspective view of the connection object to be connected to the connector of Embodiment 1, as viewed from an obliquely lower position.

FIG. 13 is a perspective view showing an inner contact used in the connector of Embodiment 1.

FIG. 14 is a front view showing the inner contact used in the connector of Embodiment 1.

FIG. 15 is a side view showing the inner contact used in the connector of Embodiment 1.

FIG. 16 is a partially broken perspective view showing the inner contact to be inserted in the inner contact accommodating groove of the connector of Embodiment 1 at the start of assembling.

FIG. 17 is a cross-sectional view showing the connector of Embodiment 1 at the start of assembling.

FIG. 18 is a cross-sectional view showing the connector of Embodiment 1 in the process of assembling.

FIG. 19 is another cross-sectional view showing the connector of Embodiment 1 in the process of assembling.

FIG. 20 is a partially broken perspective view showing the inner contact accommodated in the inner contact accommodating groove of the connector of Embodiment 1 in the process of assembling.

FIG. 21 is a perspective view of the connector of Embodiment 1 in the process of assembling, as viewed from an obliquely lower position.

FIG. 22 is a cross-sectional view showing the connector of Embodiment 1 connected to the connection object.

FIG. 23 is an exploded perspective view of a connector according to Embodiment 2.

FIG. 24 is a perspective view showing a bottom insulator used in the connector of Embodiment 2.

FIG. 25 is an enlarged view of a main part of FIG. 24.

FIG. 26 is a perspective view of a boss member used in the connector of Embodiment 2, as viewed from an obliquely upper position.

FIG. 27 is a perspective view of the boss member used in the connector of Embodiment 2, as viewed from an obliquely lower position.

FIG. 28 is a plan view showing the boss member used in the connector of Embodiment 2.

FIG. 29 is a cross-sectional view taken along line B-B in FIG. 28.

FIG. 30 is a cross-sectional view taken along line C-C in FIG. 28.

FIG. 31 is a perspective view of a connection object to be connected to the connector of Embodiment 2, as viewed from an obliquely upper position.

FIG. 32 is a perspective view of the connection object to be connected to the connector of Embodiment 2, as viewed from an obliquely lower position.

FIG. 33 is a perspective view showing an inner contact used in the connector of Embodiment 2.

FIG. 34 is a front view showing the inner contact used in the connector of Embodiment 2.

FIG. 35 is a cross-sectional view showing the connector of Embodiment 2 at the start of assembling.

FIG. 36 is a cross-sectional view showing the connector of Embodiment 2 in the process of assembling.

FIG. 37 is another cross-sectional view showing the connector of Embodiment 2 in the process of assembling.

FIG. 38 is a cross-sectional view showing the connector of Embodiment 2 connected to the connection object.

FIG. 39 is an exploded perspective view of a conventional connector.

FIG. 40 is a partial cross-sectional view showing the conventional connector.

DETAILED DESCRIPTION OF THE INVENTION

Embodiments of the present invention are described below based on the accompanying drawings.

Embodiment 1

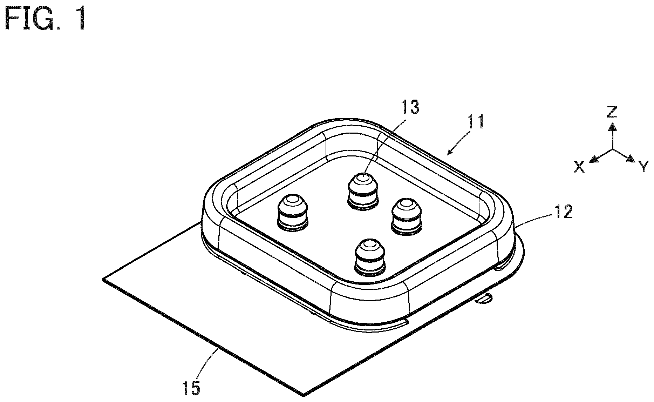

FIG. 1 shows a connector 11 according to Embodiment 1. The connector 11 is used as, for instance, a garment-side connector for fitting a wearable device and has a housing 12 made of an insulating material. Four plug contacts 13 are retained in the housing 12, and, in addition, a sheet type conductive member 15 is retained by the housing 12. The sheet type conductive member 15 constitutes a sheet type connection object to which the connector 11 is connected.

The four plug contacts 13 are arranged in two rows parallel to each other and disposed to project perpendicularly to the sheet type conductive member 15.

For convenience, the sheet type conductive member 15 is defined as extending in an XY plane, the arrangement direction of the four plug contacts 13 is referred to as "Y direction," and the direction in which the four plug contacts 13 project is referred to as "+Z direction." The Z direction is a fitting direction in which the connector 11 is fitted to a counter connector.

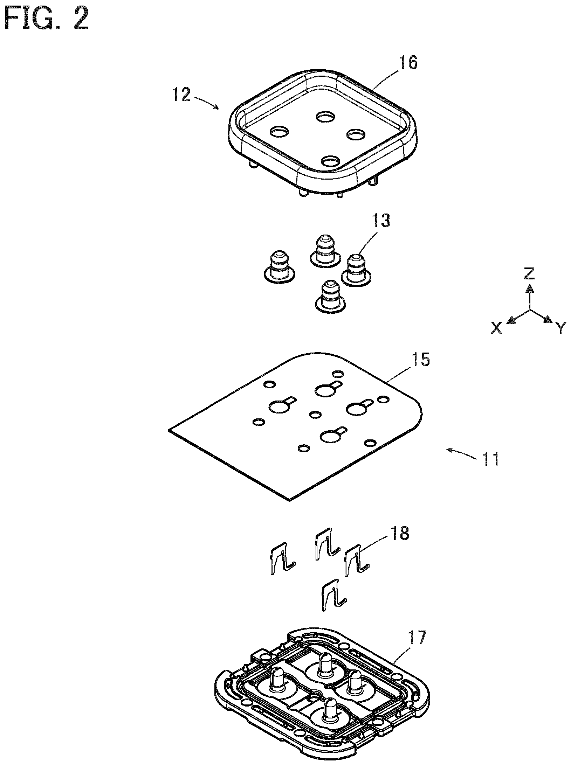

FIG. 2 shows an exploded perspective view of the connector 11. The connector 11 includes a top insulator 16 and a bottom insulator 17, and these top and bottom insulators 16 and 17 constitute the housing 12.

The four plug contacts 13 are disposed on the -Z direction side of the top insulator 16, and the sheet type conductive member 15 is disposed on the -Z direction side of the four plug contacts 13. Further, four inner contacts 18 are disposed on the -Z direction side of the sheet type conductive member 15, and the bottom insulator 17 is disposed on the -Z direction side of the four inner contacts 18. The four inner contacts 18 separately correspond to the four plug contacts 13.

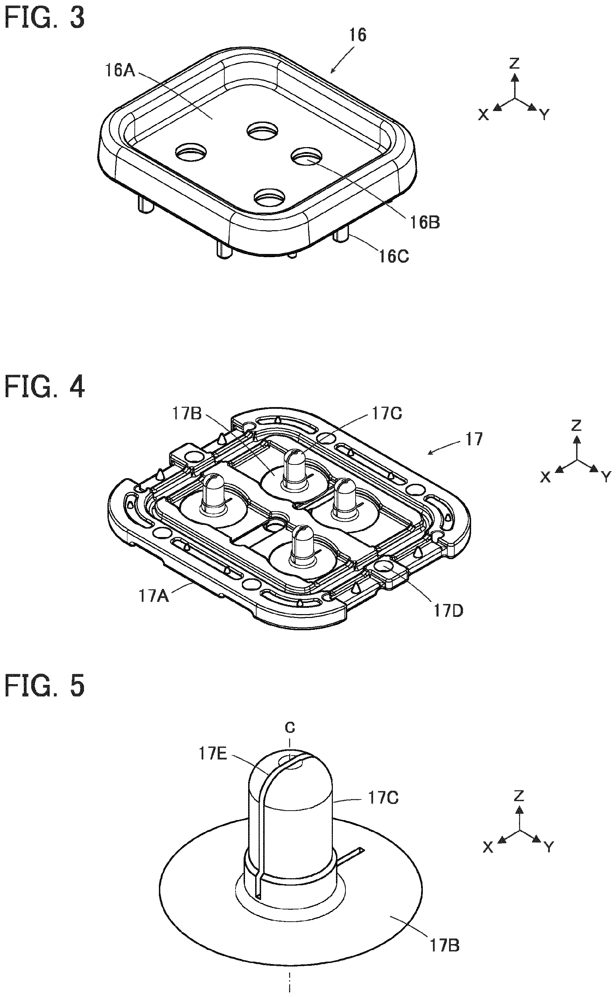

As shown in FIG. 3, the top insulator 16 includes a recessed portion 16A opening in the +Z direction, and four contact through-holes 16B formed within the recessed portion 16A. The recessed portion 16A constitutes a counter connector accommodating portion in which part of a counter connector (not shown) is to be accommodated, and the four contact through-holes 16B separately correspond to the four plug contacts 13. In addition, on a surface, facing in the -Z direction, of the top insulator 16, a plurality of bosses 16C are formed to project in the -Z direction.

As shown in FIG. 4, the bottom insulator 17 includes a flat plate portion 17A, and four contact arrangement regions 17B are defined on a top surface, facing in the +Z direction, of the flat plate portion 17A. Each contact arrangement region 17B is a circular region at which the corresponding plug contact 13 is arranged via the sheet type conductive member 15. The four contact arrangement regions 17B are separately provided with four projections 17C projecting in the +Z direction from respectively center parts of the contact arrangement regions 17B.

In addition, the flat plate portion 17A is provided with a plurality of through-holes 17D separately corresponding to the plurality of bosses 16C of the top insulator 16.

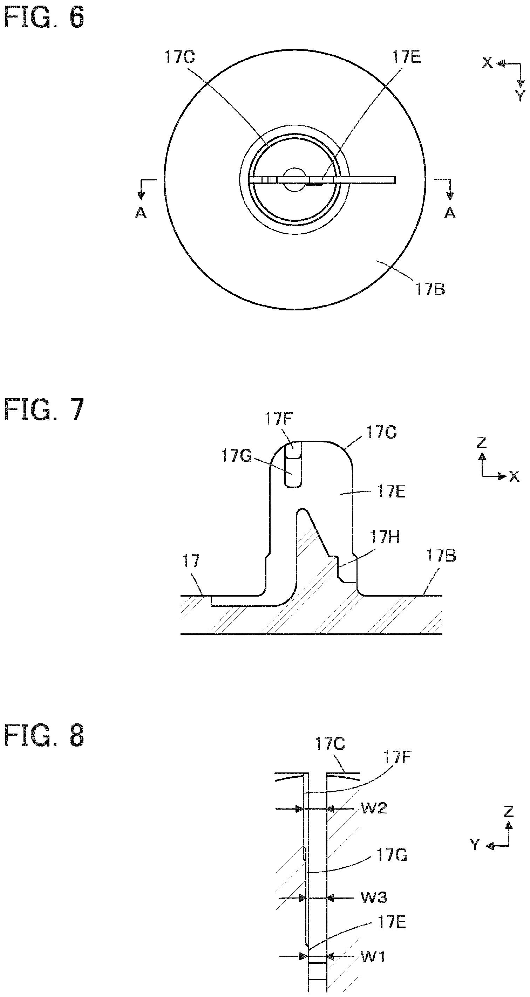

As shown in FIGS. 5 and 6, each projection 17C formed in the contact arrangement region 17B of the bottom insulator 17 has a substantially columnar shape extending in the Z direction along a fitting axis C of the plug contact 13 disposed correspondingly to the contact arrangement region 17B, and an inner contact accommodating groove 17E is formed in the projection 17C and in the contact arrangement region 17B on the -X direction side of the projection 17C.

The inner contact accommodating groove 17E is provided to accommodate the corresponding inner contact 18, passes the fitting axis C and extends along an XZ plane. The inner contact accommodating groove 17E penetrates a +Z directional portion of the projection 17C in the X direction and extends from a root part of the projection 17C to the contact arrangement region 17B as shown in FIG. 7.

In addition, the inner contact accommodating groove 17E includes: a first accommodating groove 17F formed at a +Z directional end portion, which serves as an opening end portion, of the inner contact accommodating groove 17E; and a second accommodating groove 17G disposed at an inner part on the -Z direction side of the first accommodating groove 17F and communicating with the first accommodating groove 17F. These first and second accommodating grooves 17F and 17G have different groove widths. That is, as shown in FIG. 8, as compared to a Y directional groove width W1 of the other part of the inner contact accommodating groove 17E than the first accommodating groove 17F and the second accommodating groove 17G, the first accommodating groove 17F has a first groove width W2 wider than the groove width W1, while the second accommodating groove 17G has a second groove width W3 wider than the groove width W1 and narrower than the first groove width W2.

Further, as shown in FIG. 7, the projection 17C has a restriction portion 17H disposed inside the inner contact accommodating groove 17E and formed from a surface facing in the +X direction.

The four plug contacts 13 are each made of a conductive material such as metal, and are to be connected to corresponding contacts of a counter connector (not shown) when part of the counter connector is accommodated in the recessed portion 16A of the top insulator 16.

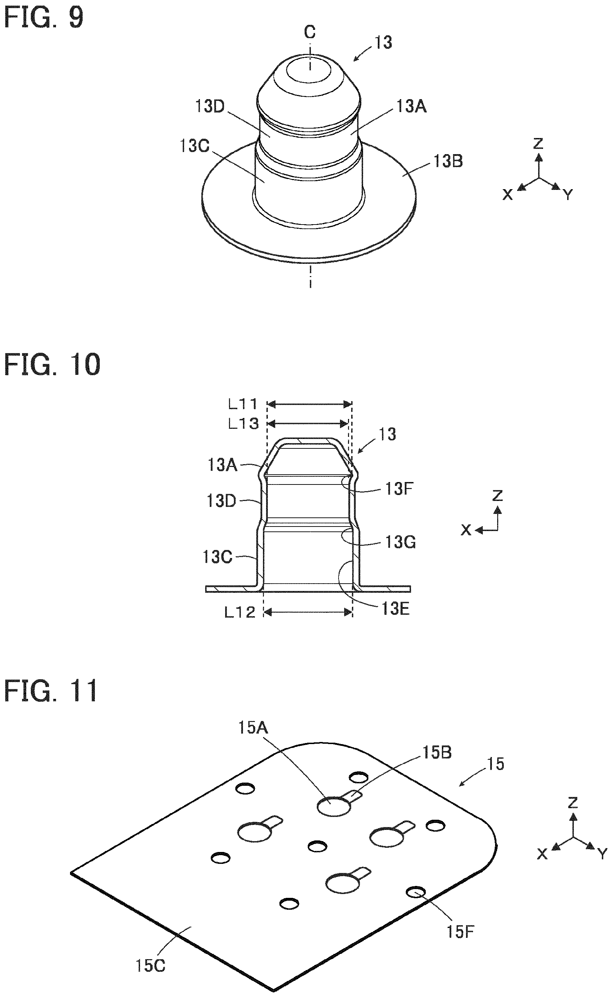

As shown in FIG. 9, the plug contact 13 has a tubular portion 13A of cylindrical shape extending in the Z direction along the fitting axis C, and a flange 13B of flat plate shape extending from a -Z directional end portion of the tubular portion 13A along an XY plane. The tubular portion 13A includes a large diameter portion 13C situated on the -Z direction side and a small diameter portion 13D concentrically connected to the large diameter portion 13C on the +Z direction side of the large diameter portion 13C.

As shown in FIG. 10, the tubular portion 13A is provided in its interior with a recessed portion 13E opening in the -Z direction, and a receiving portion 13F is formed of a dent annularly extending along an XY plane in an inner surface of the recessed portion 13E at a +Z directional end portion of the small diameter portion 13D. In addition, a step portion 13G annularly extending along an XY plane is formed in the inner surface of the recessed portion 13E at a boundary portion between the large diameter portion 13C and the small diameter portion 13D.

A distance L11 in the X direction from the receiving portion 13F to a part of an inner surface of the small diameter portion 13D which part faces the receiving portion 13F has a value smaller than an inside diameter L12 of the large diameter portion 13C and larger than an inside diameter L13 of the small diameter portion 13D.

The fitting axis C is an axis passing the center of the tubular portion 13A and extending in the Z direction that is the fitting direction between the connector 11 and a counter connector.

While the tubular portion 13A has a cylindrical shape, the cross-sectional shape thereof is not limited to a circular shape, and the tubular portion 13A may have various cross-sectional shapes such as an elliptical shape and a polygonal shape as long as the tubular portion 13A is provided in its interior with the recessed portion 13E.

Any of the four plug contacts 13 may be each used as a terminal for transmitting an electric signal.

The sheet type conductive member 15 has a multilayer structure in which a plurality of wiring layers each formed from a conductor and a plurality of insulating layers are laminated.

As shown in FIG. 11, the sheet type conductive member 15 is provided with four circular opening portions 15A penetrating the sheet type conductive member 15 in the Z direction. The four opening portions 15A separately correspond to the four plug contacts 13. On a top surface, facing in the +Z direction, of the sheet type conductive member 15, a wiring layer 15B is exposed toward the +Z direction at parts separately adjacent to the opening portions 15A on the -X direction side of the opening portions 15A, while an insulating layer 15C is exposed in a region excluding the four opening portions 15A and the four parts of the wiring layer 15B adjacent to these opening portions 15A.

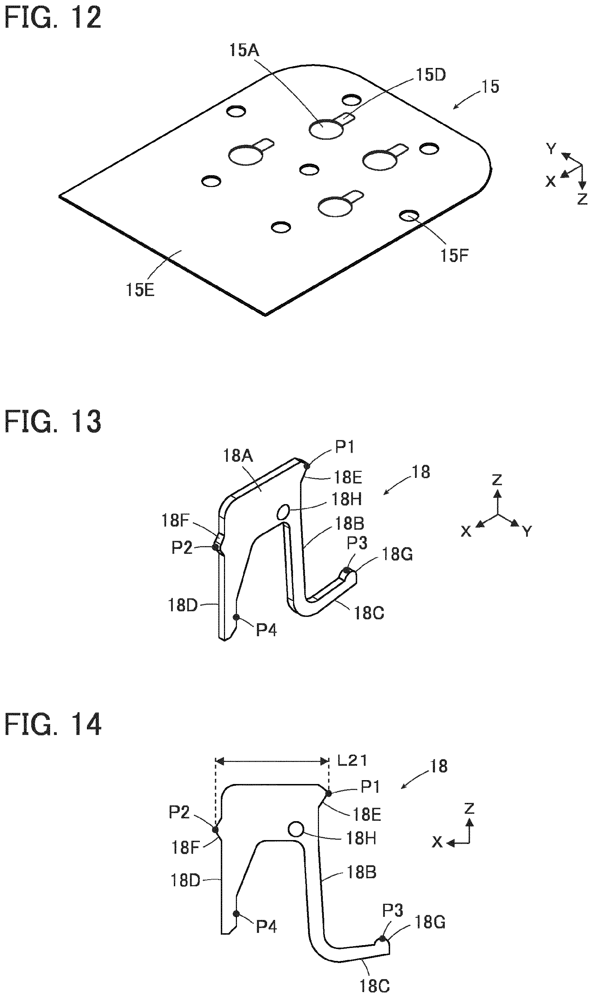

Since the opening portions 15A penetrate the sheet type conductive member 15 in the Z direction, as shown in FIG. 12, the four opening portions 15A can be seen also on a bottom surface, facing in the -Z direction, of the sheet type conductive member 15.

On the bottom surface, facing in the -Z direction, of the sheet type conductive member 15, a wiring layer 15D is exposed toward the -Z direction at parts separately adjacent to the four opening portions 15A on the -X direction side of the opening portions 15A, while an insulating layer 15E is exposed in a region excluding the four opening portions 15A and the four parts of the wiring layer 15D adjacent to these opening portions 15A.

In addition, as shown in FIGS. 11 and 12, a plurality of through-holes 15F separately corresponding to the plurality of bosses 16C of the top insulator 16 are formed at a peripheral portion of the sheet type conductive member 15.

As shown in FIGS. 13 and 14, the inner contact 18 is formed of a metal sheet of flat plate shape that is cut in a predetermined shape and has conductivity, and has a flat plate portion 18A extending along an XZ plane. A first extending portion 18B extends in the -Z direction from a -X directional end portion of the flat plate portion 18A, an arm portion 18C extends in the -X direction from a -Z directional end portion of the first extending portion 18B, and a second extending portion 18D extends in the -Z direction from a +X directional end portion of the flat plate portion 18A. The flat plate portion 18A, the first extending portion 18B, and the second extending portion 18D are inserted into the recessed portion 13E of the corresponding plug contact 13 when the connector 11 is assembled.

A hook portion 18E is formed at the -X directional and +Z directional end portion of the flat plate portion 18A to project in the -X direction. The hook portion 18E projects in a right angle shape or a chevron shape toward the -X direction, and a first contacting portion P1 facing in the -Z direction is set at a -X directional end portion of the hook portion 18E.

A protruding portion 18F protruding in a convex shape in the +X direction is formed at the +X directional end portion of the flat plate portion 18A on the -Z direction side from the first contacting portion P1, and a second contacting portion P2 facing in the +X direction is set on a +X directional end portion of the protruding portion 18F.

A distance L21 in the X direction between the first contacting portion P1 and the second contacting portion P2 is slightly larger than the distance L11 in the X direction from the receiving portion 13D to a part of the inner surface of the small diameter portion 13D which part faces the receiving portion 13D, is smaller than the inside diameter L12 of the large diameter portion 13C, and is larger than the inside diameter L13 of the small diameter portion 13D in the plug contact 13 shown in FIG. 10.

In addition, a protruding portion 18G protruding in a convex shape toward the +Z direction is formed at a -X directional end portion of the arm portion 18C, and a third contacting portion P3 facing in the +Z direction is set on a +Z directional end portion of the protruding portion 18G.

A restricted portion P4 facing in the -X direction is set on a lateral surface of a -Z directional end portion of the second extending portion 18D facing the first extending portion 18B.

Further, a press-fitting portion 18H of convex shape is formed on a surface, facing in the +Y direction, of the flat plate portion 18A to protrude in the +Y direction. The press-fitting portion 18H is formed by, for example, exerting a pressing force on the flat plate portion 18A from the -Y direction and deforming the flat plate portion 18A.

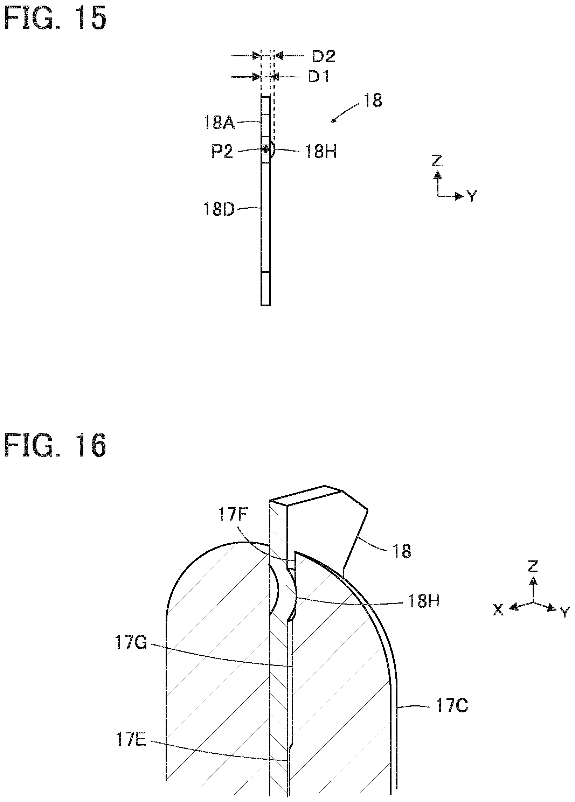

Due to the presence of the press-fitting portion 18H as above, as shown in FIG. 15, a thickness D2 of the inner contact 18 at a part where the press-fitting portion 18H is formed is larger than a thickness D1 of the inner contact 18 at a part where the press-fitting portion 18H is not formed.

In addition, the press-fitting portion 18H is formed at an X directional position corresponding to the first accommodating groove 17F and the second accommodating groove 17G of the projection 17C of the bottom insulator 17 shown in FIG. 7.

It is configured such that the groove width W1 of the inner contact accommodating groove 17E of the projection 17C of the bottom insulator 17 shown in FIG. 8 is slightly larger than the thickness D1 of the inner contact 18 at the part where the press-fitting portion 18H is not formed, the first groove width W2 of the first accommodating groove 17F is substantially equal to the thickness D2 of the inner contact 18 at the part where the press-fitting portion 18H is formed, and the second groove width W3 of the second accommodating groove 17G is smaller than the thickness D2 of the inner contact 18 at the part where the press-fitting portion 18H is formed.

The four contact through-holes 16B of the top insulator 16, the four plug contacts 13, the four opening portions 15A of the sheet type conductive member 15, the four inner contacts 18, and the four contact arrangement regions 17B of the bottom insulator 17 are arranged so as to align with each other in the Z direction.

In addition, the bosses 16C of the top insulator 16, the through-holes 15F of the sheet type conductive member 15, and the through-holes 17D of the bottom insulator 17 are arranged so as to align with each other in the Z direction.

When the connector 11 is assembled, first, the four inner contacts 18 are separately retained in the inner contact accommodating grooves 17E of the four projections 17C of the bottom insulator 17. Since the first accommodating groove 17F formed at the +Z directional end portion of the inner contact accommodating groove 17E of the projection 17C has the first groove width W2 substantially equal to the thickness D2 of the inner contact 18 at the part where the press-fitting portion 18H is formed, as shown in FIG. 16, each inner contact 18 is retained in a state where the press-fitting portion 18H is inserted into the first accommodating groove 17F of the corresponding projection 17C from the +Z direction and is situated at the boundary portion between the first accommodating groove 17F and the second accommodating groove 17G.

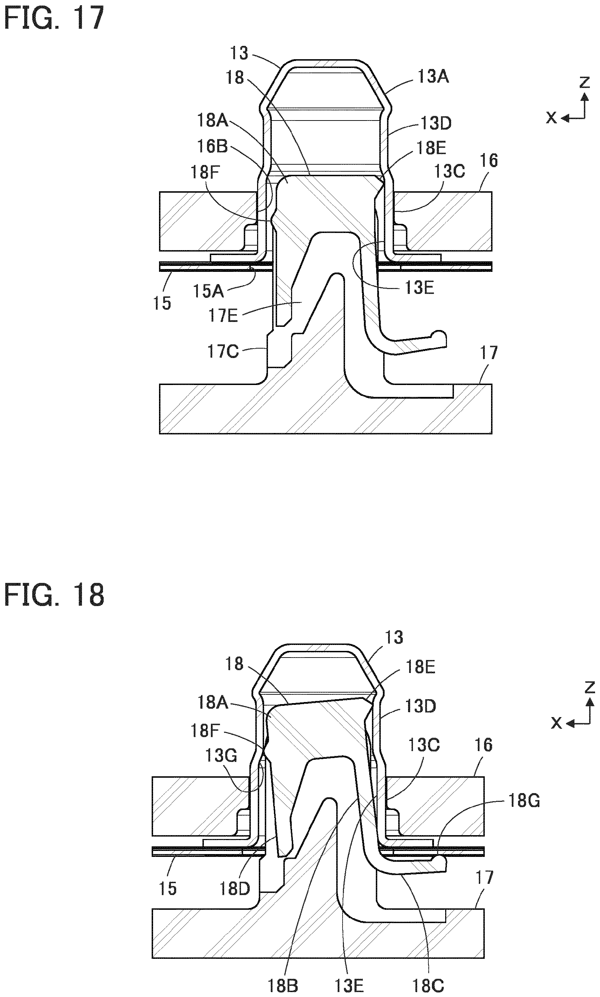

Subsequently, as shown in FIG. 17, the tubular portion 13A of each plug contact 13 is inserted into the corresponding one of the four contact through-holes 16B of the top insulator 16 from the -Z direction, and the bottom insulator 17 is pressed toward the top insulator 16 in the +Z direction with the sheet type conductive member 15 being sandwiched therebetween.

At this time, the inner contact 18 retained by the inner contact accommodating groove 17E of the projection 17C of the bottom insulator 17 is pushed up in the +Z direction along with the bottom insulator 17, and the flat plate portion 18A of the inner contact 18 is inserted into the recessed portion 13E of the corresponding plug contact 13 through the opening portion 15A of the sheet type conductive member 15.

Here, the distance L21 in the X direction between the -X directional end portion of the hook portion 18E and the +X directional end portion of the protruding portion 18F of the inner contact 18 shown in FIG. 14 is smaller than the inside diameter L12 of the large diameter portion 13C and larger than the inside diameter L13 of the small diameter portion 13D of the plug contact 13. Therefore, while the flat plate portion 18A of the inner contact 18 can move in the +Z direction within the large diameter portion 13C of the plug contact 13, the protruding portion 18F situated on the -Z direction side from the hook portion 18E cannot enter the small diameter portion 13D and is hooked by the step portion 13G situated at the boundary portion between the large diameter portion 13C and the small diameter portion 13D as shown in FIG. 18.

As a result, the inner contact 18 takes a position rotated counterclockwise by a predetermined angle in FIG. 18 and moves in the +Z direction within the recessed portion 13E of the plug contact 13.

Accordingly, the first extending portion 18B and the second extending portion 18D of the inner contact 18 are also inserted into the recessed portion 13E of the plug contact 13, and further, the protruding portion 18G formed at the -X directional end portion of the arm portion 18C extending in the -X direction from the -Z directional end portion of the first extending portion 18B makes contact with the bottom surface on the -Z direction side of the sheet type conductive member 15.

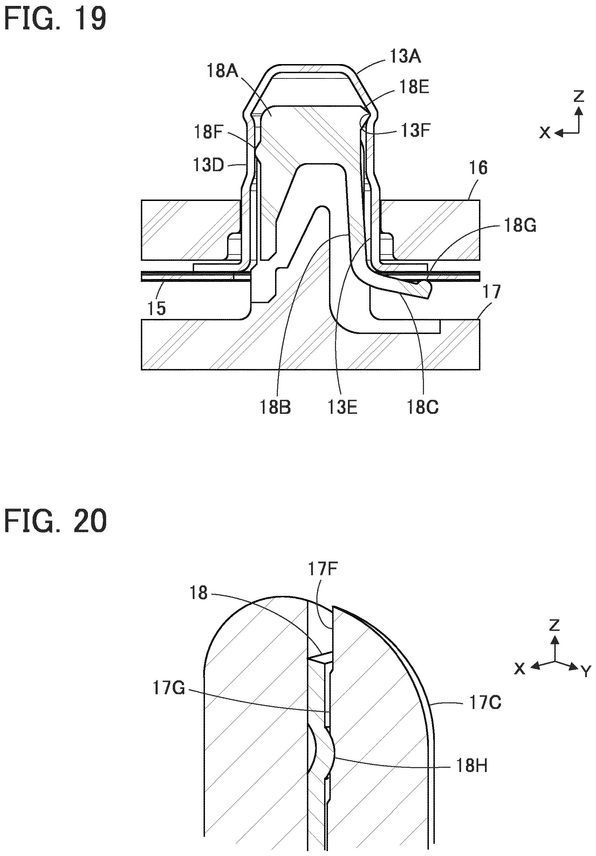

When the bottom insulator 17 is further pressed in the +Z direction in this state, the flat plate portion 18A moves in the +Z direction while the first extending portion 18B and the arm portion 18C of the inner contact 18 are elastically deformed, and as shown in FIG. 19, the hook portion 18E is received by the receiving portion 13F formed in the recessed portion 13E of the plug contact 13.

Consequently, the inner contact 18 is rotated clockwise in FIG. 19 and retained by the plug contact 13 in a state where the protruding portion 18G of the arm portion 18C is pressed in the -Z direction from the sheet type conductive member 15, and the protruding portion 18F of the flat plate portion 18A is pressed in the -X direction from the inner surface of the small diameter portion 13D of the plug contact 13.

Further, when the bottom insulator 17 is pressed in the +Z direction toward the top insulator 16, since the inner contact 18 is retained by the plug contact 13, the projection 17C of the bottom insulator 17 moves in the +Z direction relatively to the inner contact 18, and as shown in FIG. 20, the press-fitting portion 18H of the inner contact 18 is inserted into the second accommodating groove 17G from the first accommodating groove 17F of the corresponding projection 17C.

Here, since the second groove width W3 of the second accommodating groove 17G of the projection 17C shown in FIG. 8 has the second groove width W3 narrower than the thickness D2 of the inner contact 18 at the part where the press-fitting portion 18H is formed, the press-fitting portion 18H is press-fitted in the second accommodating groove 17G of the projection 17C, and the inner contact 18 is thus retained by the projection 17C of the bottom insulator 17.

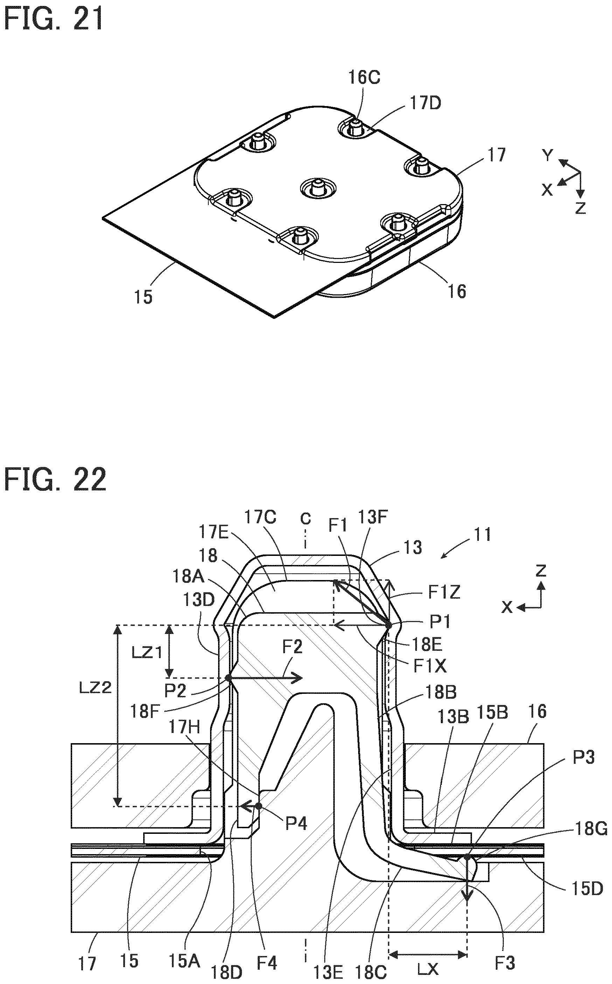

In addition, by pressing the bottom insulator 17 against the top insulator 16, the bosses 16C of the top insulator 16 sequentially penetrate the through-holes 15F of the sheet type conductive member 15, and the through-holes 17D of the bottom insulator 17. Thereafter, as shown in FIG. 21, the top insulator 16 and the bottom insulator 17 are fixed to each other through heat deformation of a tip of each of the plurality of bosses 16C projecting on the -Z direction side of the bottom insulator 17. Thus, the assembling operation of the connector 11 is completed.

In the connector 11 assembled as above, as shown in FIG. 22, the restricted portion P4 set at the -Z directional end portion of the second extending portion 18D of the inner contact 18 makes contact with the restriction portion 17H formed inside the inner contact accommodating groove 17E of the projection 17C of the bottom insulator 17, whereby counterclockwise rotation of the inner contact 18 in FIG. 22 is restricted.

In addition, the flange 13B of the plug contact 13 is situated around the corresponding opening portion 15A of the sheet type conductive member 15, and the sheet type conductive member 15 is sandwiched between the protruding portion 18G formed at the -X directional end portion of the arm portion 18C of the inner contact 18 and a bottom surface on the -Z direction side of the flange 13B of the plug contact 13.

The inner contact 18 is retained in a state where the first contacting portion P1 set at the hook portion 18E of the flat plate portion 18A is receiving a force F1 acting in the +X direction and the +Z direction from the receiving portion 13F of the plug contact 13, the second contacting portion P2 set at the protruding portion 18F of the flat plate portion 18A is receiving a force F2 acting in the -X direction from the inner surface of the small diameter portion 13D of the plug contact 13, the third contacting portion P3 set at the protruding portion 18G of the arm portion 18C is receiving a force F3 acting in the -Z direction from the bottom surface of the sheet type conductive member 15, and the restricted portion P4 set at the second extending portion 18D is receiving a force F4 acting in the +X direction from the restriction portion 17H of the bottom insulator 17.

Thus, the first and second contacting portions P1 and P2 are pressed against and make contact with the inner surface of the recessed portion 13E of the plug contact 13, whereby the inner contact 18 is electrically connected to the plug contact 13.

In addition, the top surface on the +Z direction side of the sheet type conductive member 15 is pressed against the bottom surface of the flange 13B of the plug contact 13, while the bottom surface on the -Z direction side of the sheet type conductive member 15 is pressed against the third contacting portion P3 of the inner contact 18.

Here, as shown in FIGS. 11 and 12, on the top surface of the sheet type conductive member 15, the wiring layer 15B is exposed at parts separately adjacent to the opening portions 15A on the -X direction side of the opening portions 15A, and on the bottom surface of the sheet type conductive member 15, the wiring layer 15D is exposed at separately adjacent to the opening portions 15A on the -X direction side of the opening portions 15A.

Therefore, the wiring layer 15B on the top surface of the sheet type conductive member 15 makes contact with the bottom surface of the flange 13B of the plug contact 13 with predetermined contact pressure, while the wiring layer 15D on the bottom surface of the sheet type conductive member 15 makes contact with the third contacting portion P3 of the inner contact 18 with predetermined contact pressure.

Therefore, the wiring layer 15B exposed on the top surface of the sheet type conductive member 15 is electrically connected to the plug contact 13 directly, and the wiring layer 15D exposed on the bottom surface of the sheet type conductive member 15 is electrically connected to the plug contact 13 via the inner contact 18. In other words, both the wiring layers 15B and 15D are connected to the plug contact 13.

Thus, in the connector 11, both the wiring layer 15B and the wiring layer 15D formed of the conductors disposed on the top surface side and the bottom surface side of the sheet type conductive member 15 can be electrically connected to a single plug contact 13 by use of the inner contact 18.

Therefore, when the connector 11 is connected to a sheet type conductive member having a conductor exposed only on its top surface side, the plug contact 13 can be electrically connected to the conductor on the top surface side of the sheet type conductive member. On the other hand, when the connector 11 is connected to a sheet type conductive member having a conductor exposed only on its bottom surface side, the plug contact 13 can be electrically connected to the conductor on the bottom surface side of the sheet type conductive member.

Further, when the connector 11 is connected to a sheet type conductive member having conductors separately exposed on its top surface side and bottom surface side like the sheet type conductive member 15 in Embodiment 1 above, the plug contact 13 can be electrically connected to both the conductors on the top surface side and the bottom surface side of the sheet type conductive member. For example, assuming that a connection object is a sheet type conductive member having a multilayer structure in which conductors constituting shield layers are separately exposed on the top surface side and the bottom surface side and a conductor constituting a signal wiring layer is disposed between these shield layers so as to be insulated from both the shield layers, a shield effect is exhibited to the signal wiring layer when the plug contact 13 connected to the shield layers on the top surface side and the bottom surface side is connected to a ground potential, and it is possible to carry out highly accurate signal transmission with reduced influence of external disturbances caused by, for example, electromagnetic waves.

Note that the flange 13B of each of the plug contacts 13 is sandwiched between the top insulator 16 and the bottom insulator 17, and the plug contacts 13 are thereby fixed to the top insulator 16 and the bottom insulator 17.

In addition, the inner contact 18 is retained while receiving the forces F1 to F4, and if a frictional force is ignored, the force F1 applied to the first contacting portion P1, the force F2 applied to the second contacting portion P2, the force F3 applied to the third contacting portion P3, and the force F4 applied to the restricted portion P4 balance with one another.

That is, when an X directional component force and a Z directional component force of the force F1 are F1X and F1Z, respectively, the following relations are established:

$$F2 = F1X + F4 \cdots (1),$$

and

$$F3 = F1Z \cdots (2).$$

Note that F1, F2, F3, F4, F1X, and F1Z are expressed in their absolute values.

For example, from balance of the moments about the first contacting portion P1, when a distance in the X direction between the first contacting portion P1 and the third contacting portion P3 is LX, a distance in the Z direction between the first contacting portion P1 and the second contacting portion P2 is LZ1, and a distance in the Z direction between the first contacting portion P1 and the restricted portion P4 is LZ2, the following relation is established:

$$(F2 \times LZ1) = (F3 \times LX) + (F4 \times LX2) \cdots (3).$$

As can be seen from Formula (3) above, since the force F4 is applied to the restricted portion P4, the distance LX in the X direction between the first contacting portion P1 and the third contacting portion P3 can be decreased. If the restricted portion P4 of the inner contact 18 does not contact the restriction portion 17H of the projection 17C of the bottom insulator 17 and does not receive the force F4 acting in the +X direction from the restriction portion 17H, in order to retain the inner contact 18 with the balanced moments, it is necessary to increase the distance LX in the X direction between the first contacting portion P1 and the third contacting portion P3 to increase the clockwise moments in FIG. 22. That is, the length of the arm portion 18C extending in the X direction would need to be made larger, resulting in enlargement of the connector 11.

According to Embodiment 1, even when the wiring layer 15B or 15D is exposed on either of the top surface and the bottom surface of the sheet type conductive member 15, the plug contact 13 can be electrically connected to the wiring layer 15B or 15D of the sheet type conductive member 15, and the small-sized connector 11 can be achieved.

Embodiment 2

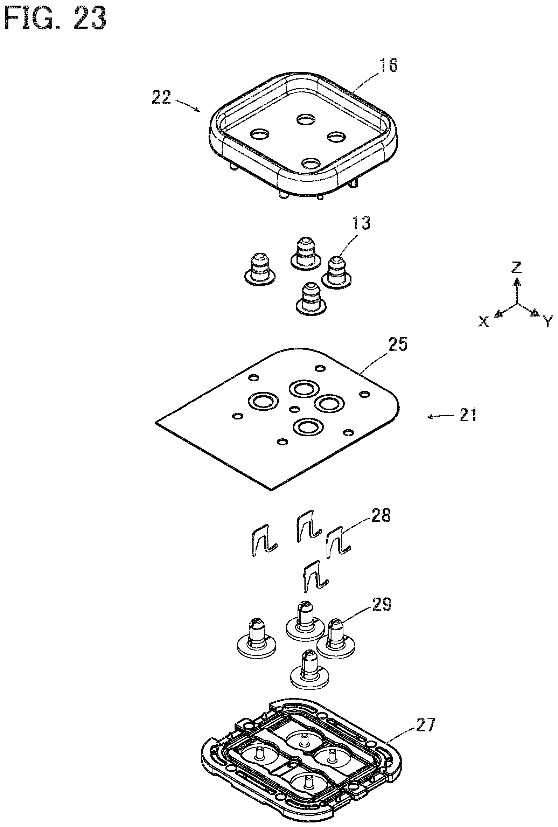

FIG. 23 shows an exploded perspective view of a connector 21 according to Embodiment 2. The connector 21 includes a housing 22 constituted of the top insulator 16 and a bottom insulator 27.

The four plug contacts 13 are disposed on the -Z direction side of the top insulator 16, and a sheet type conductive member 25 is disposed on the -Z direction side of the four plug contacts 13. Further, four inner contacts 28 are disposed on the -Z direction side of the sheet type conductive member 25, four boss members 29 are disposed on the -Z direction side of the four inner contacts 28, and the bottom insulator 27 is disposed on the -Z direction side of the four boss members 29.

The top insulator 16 and the four plug contacts 13 are the same as those used in the connector 11 of Embodiment 1.

In addition, the four inner contacts 28 and the four boss members 29 correspond to the four plug contacts 13.

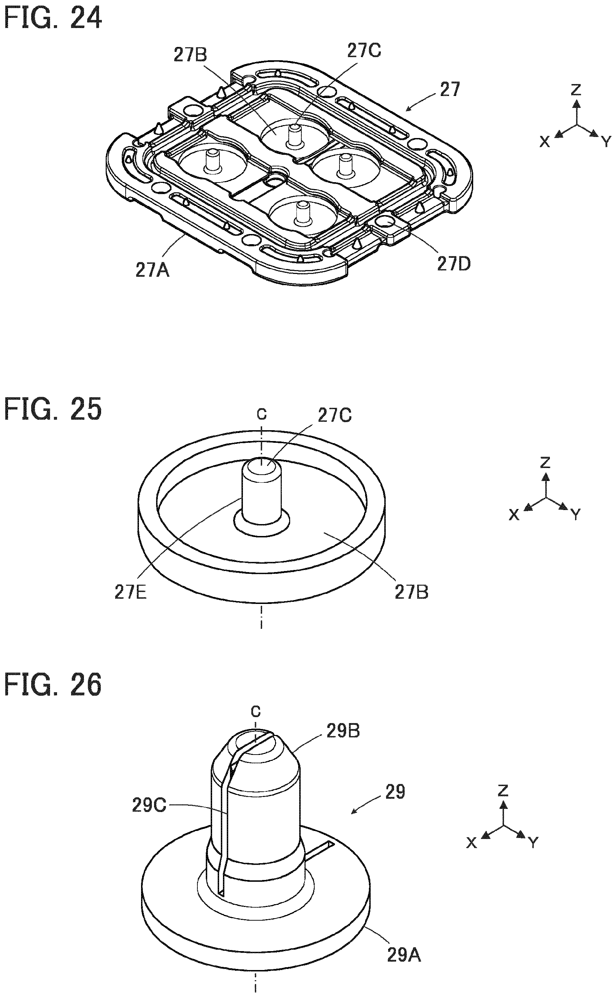

As shown in FIG. 24, the bottom insulator 27 includes a flat plate portion 27A, and four contact arrangement regions 27B are defined on a top surface, facing in the +Z direction, of the flat plate portion 27A. Each contact arrangement region 27B is a circular region at which the corresponding plug contact 13 is arranged via the sheet type conductive member 25. The four contact arrangement regions 27B are separately provided with four protrusion portions 27C projecting in the +Z direction from respective center parts of the contact arrangement regions 27B.

In addition, the flat plate portion 27A is provided with a plurality of through-holes 27D separately corresponding to the plurality of bosses 16C of the top insulator 16.

As shown in FIG. 25, the contact arrangement region 27B of the bottom insulator 27 has a recessed and circular shape, and the protrusion portion 27C has a columnar shape extending in the Z direction along the fitting axis C of the plug contact 13 disposed correspondingly to the contact arrangement region 27B. A lateral surface along an outer periphery of the protrusion portion 27C forms a restriction portion 27E.

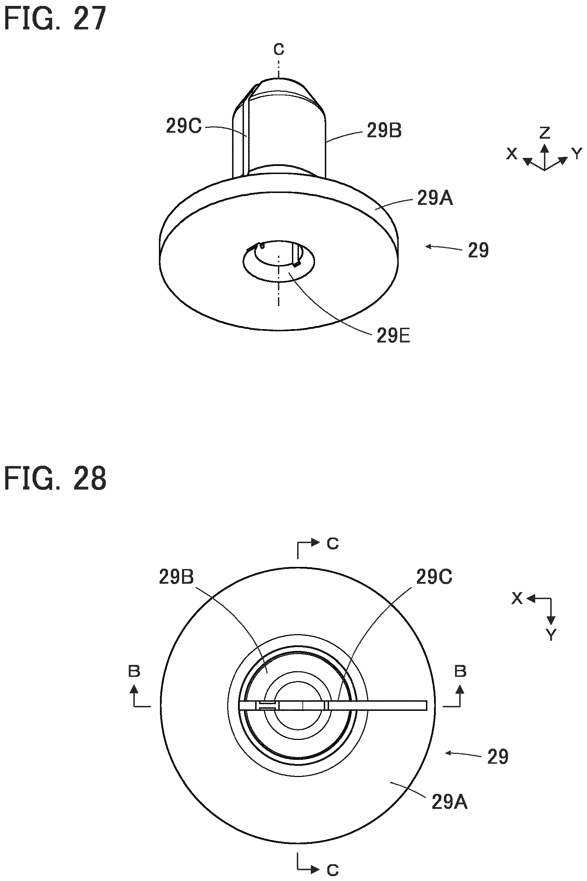

As shown in FIGS. 26 to 28, the boss member 29 includes a base portion 29A of circular disk shape and a projection 29B projecting in the +Z direction from a center part of the base portion 29A, and an inner contact accommodating groove 29C is formed in the projection 29B and the base portion 29A on the -X direction side of the projection 29B. In addition, the base portion 29A has such a size as to be accommodated in the contact arrangement region 27B of recess shape of the bottom insulator 27.

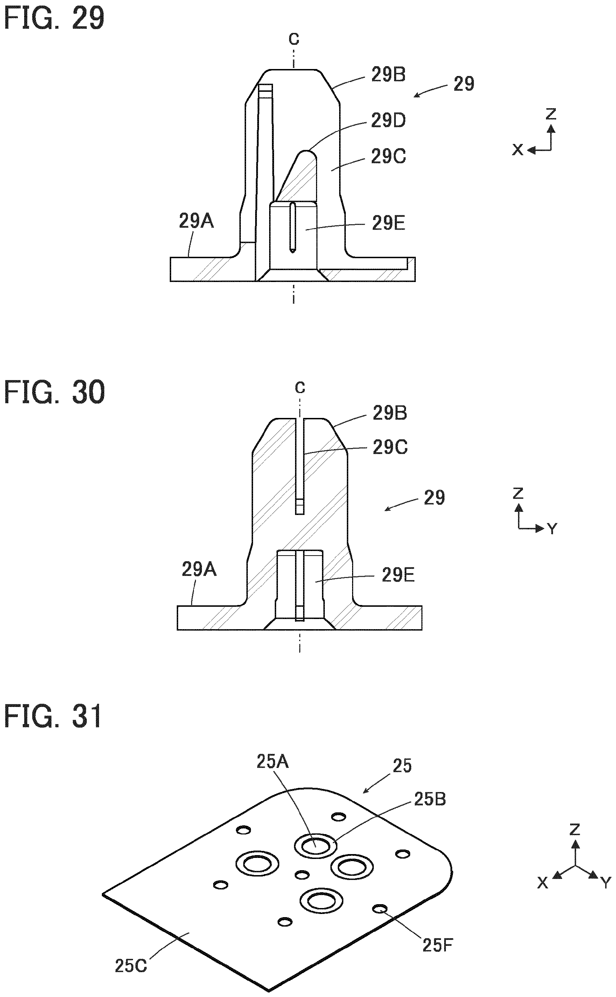

The inner contact accommodating groove 29C is configured to accommodate the corresponding inner contact 28, passes the fitting axis C and extends along an XZ plane. The inner contact accommodating groove 29C penetrates a +Z directional portion of the projection 29B in the X direction and extends from a root part of the projection 29B to the base portion 29A as shown in FIG. 29. The inner contact accommodating groove 29C has a Y directional groove width slightly larger than the thickness of the inner contact 28.

In addition, the projection 29B includes an abutment portion 29D disposed inside the inner contact accommodating groove 29C and facing in the +Z direction.

In addition, as shown in FIGS. 29 and 30, the boss member 29 includes a protrusion portion accommodating hole 29E extending from a bottom surface on the -Z direction side of the base portion 29A along the fitting axis C to the inside of the projection 29B and communicating with the inner contact accommodating groove 29C. The protrusion portion accommodating hole 29E opens in the -Z direction from the bottom surface on the -Z direction side of the base portion 29A and is configured to accommodate the protrusion portion 27C of the bottom insulator 27 when the connector 21 is assembled.

The sheet type conductive member 25 has a multilayer structure in which a plurality of wiring layers each formed from a conductor and a plurality of insulating layers are laminated.

As shown in FIG. 31, the sheet type conductive member 25 is provided with four circular opening portions 25A penetrating the sheet type conductive member 25 in the Z direction. The four opening portions 25A separately correspond to the four plug contacts 13. On a top surface, facing in the +Z direction, of the sheet type conductive member 25, a wiring layer 25B is exposed toward the +Z direction and around each of the opening portions 25A so as to surround the opening portions 25A, while an insulating layer 25C is exposed in a region excluding the four opening portions 25A and the four parts of the wiring layer 25B disposed around these opening portions 25A.

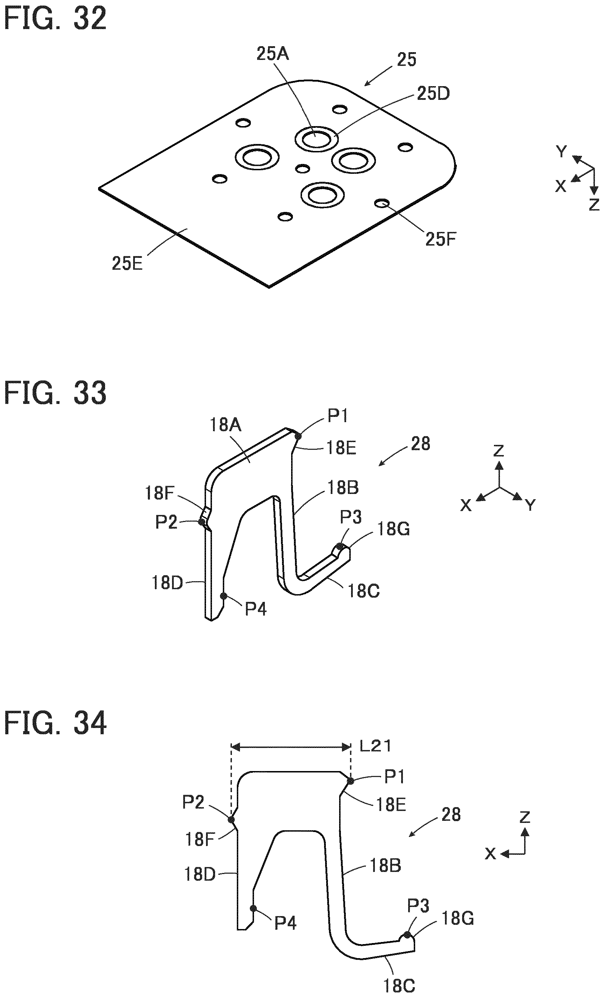

Since the opening portions 25A penetrate the sheet type conductive member 25 in the Z direction, as shown in FIG. 32, the four opening portions 25A can be seen also on a bottom surface, facing in the -Z direction, of the sheet type conductive member 25.

On the bottom surface, facing in the -Z direction, of the sheet type conductive member 25, a wiring layer 25D is exposed toward the -Z direction and around the four opening portions 25A so as to surround the opening portions 25A, while an insulating layer 25E is exposed in a region excluding the four opening portions 25A and the four parts of the wiring layer 25D disposed around these opening portions 25A.

In addition, as shown in FIGS. 31 and 32, a plurality of through-holes 25F separately corresponding to the plurality of bosses 16C of the top insulator 16 are formed at a peripheral portion of the sheet type conductive member 25.

FIGS. 33 and 34 show the inner contact 28. The inner contact 28 does not have the press-fitting portion 18H formed on the surface of the flat plate portion 18A in the inner contact 18 used in Embodiment 1, and the configuration of the inner contact 28 is the same as that of the inner contact 18 expect the press-fitting portion 18H.

More specifically, the inner contact 28 is formed from a metal sheet of flat plate shape that is cut in a predetermined shape and has conductivity, and includes the flat plate portion 18A extending along an XZ plane, the first extending portion 18B extending in the -Z direction from the -X directional end portion of the flat plate portion 18A, the arm portion 18C extending in the -X direction from the -Z directional end portion of the first extending portion 18B, and the second extending portion 18D extending in the -Z direction from the +X directional end portion of the flat plate portion 18A.

The hook portion 18E projecting in the -X direction is formed at the -X directional and +Z directional end portion of the flat plate portion 18A, and the first contacting portion P1 facing in the -Z direction is set at the -X directional end portion of the hook portion 18E.

In addition, the protruding portion 18F protruding in the +X direction is formed at a +X directional end portion of the flat plate portion 18A on the -Z direction side from the first contacting portion P1, and the second contacting portion P2 facing in the +X direction is set at the +X directional end portion of the protruding portion 18F.

The distance L21 in the X direction between the first contacting portion P1 and the second contacting portion P2 is slightly larger than the distance L11 in the X direction from the receiving portion 13D to a part of the inner surface of the small diameter portion 13D which part faces the receiving portion 13D, is smaller than the inside diameter L12 of the large diameter portion 13C, and is larger than the inside diameter L13 of the small diameter portion 13D in the plug contact 13 shown in FIG. 10.

In addition, the protruding portion 18G protruding in the +Z direction is formed at the -X directional end portion of the arm portion 18C, and the third contacting portion P3 facing in the +Z direction is set at a +Z directional end portion of the protruding portion 18G.

The restricted portion P4 facing in the -X direction is set on a part of the lateral surface of a -Z directional end portion of the second extending portion 18D which part faces the first extending portion 18B.

The four contact through-holes 16B of the top insulator 16, the four plug contacts 13, the four opening portions 25A of the sheet type conductive member 25, the four inner contacts 28, the four boss members 29, and the four contact arrangement regions 27B of the bottom insulator 27 are arranged so as to align with each other in the Z direction.

In addition, the bosses 16C of the top insulator 16, the through-holes 25F of the sheet type conductive member 25, and the through-holes 27D of the bottom insulator 27 are arranged so as to align with each other in the Z direction.

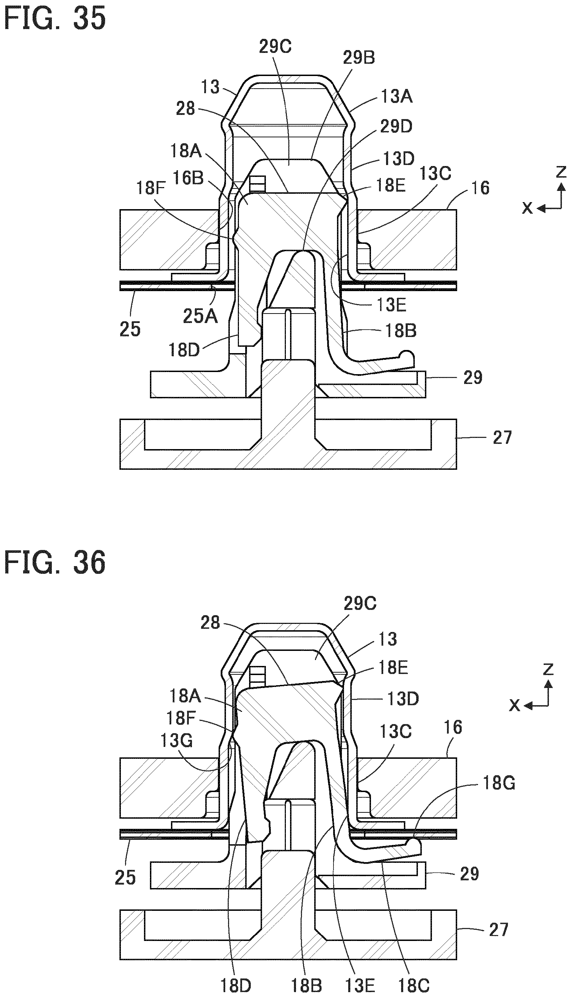

When the connector 21 is assembled, first, the four inner contacts 28 are separately retained by the inner contact accommodating grooves 29C of the projections 29B of the four boss members 29. The inner contact accommodating groove 29C has a Y directional groove width slightly larger than the thickness of the inner contact 28, the inner contact 28 is inserted into the inner contact accommodating groove 29C from the +Z direction, and as shown in FIG. 35, the inner contact 28 is retained in a state where a -Z directional end portion of the flat plate portion 18A between the first extending portion 18B and the second extending portion 18D is making contact with the abutment portion 29D within the inner contact accommodating groove 29C.

Subsequently, the tubular portion 13A of each plug contact 13 is inserted into the corresponding one of the four contact through-holes 16B of the top insulator 16 from the -Z direction, and each of the four boss members 29 is pressed toward the top insulator 16 in the +Z direction with the sheet type conductive member 25 being sandwiched therebetween.

At this time, the inner contact 28 retained by the inner contact accommodating groove 29C of the projection 29B of the boss member 29 is, together with the boss member 29, pushed up in the +Z direction, and the flat plate portion 18A of the inner contact 28 is inserted into the recessed portion 13E of the corresponding plug contact 13 through the opening portion 25A of the sheet type conductive member 25.

Here, the distance L21 in the X direction between the -X directional end portion of the hook portion 18E and the +X directional end portion of the protruding portion 18F of the inner contact 28 shown in FIG. 34 is smaller than the inside diameter L12 of the large diameter portion 13C and larger than the inside diameter L13 of the small diameter portion 13D of the plug contact 13. Therefore, while the flat plate portion 18A of the inner contact 28 can move in the +Z direction within the large diameter portion 13C of the plug contact 13, the protruding portion 18F situated on the -Z direction side from the hook portion 18E cannot enter the small diameter portion 13D and is hooked by the step portion 13G situated at the boundary portion between the large diameter portion 13C and the small diameter portion 13D as shown in FIG. 36.

As a result, the inner contact 28 takes a position rotated counterclockwise by a predetermined angle in FIG. 36 and moves in the +Z direction within the recessed portion 13E of the plug contact 13.

Accordingly, the first extending portion 18B and the second extending portion 18D of the inner contact 28 are also inserted into the recessed portion 13E of the plug contact 13, and further, the protruding portion 18G formed at the -X directional end portion of the arm portion 18C extending in the -X direction from the -Z directional end of the first extending portion 18B makes contact with the bottom surface on the -Z direction side of the sheet type conductive member 25.

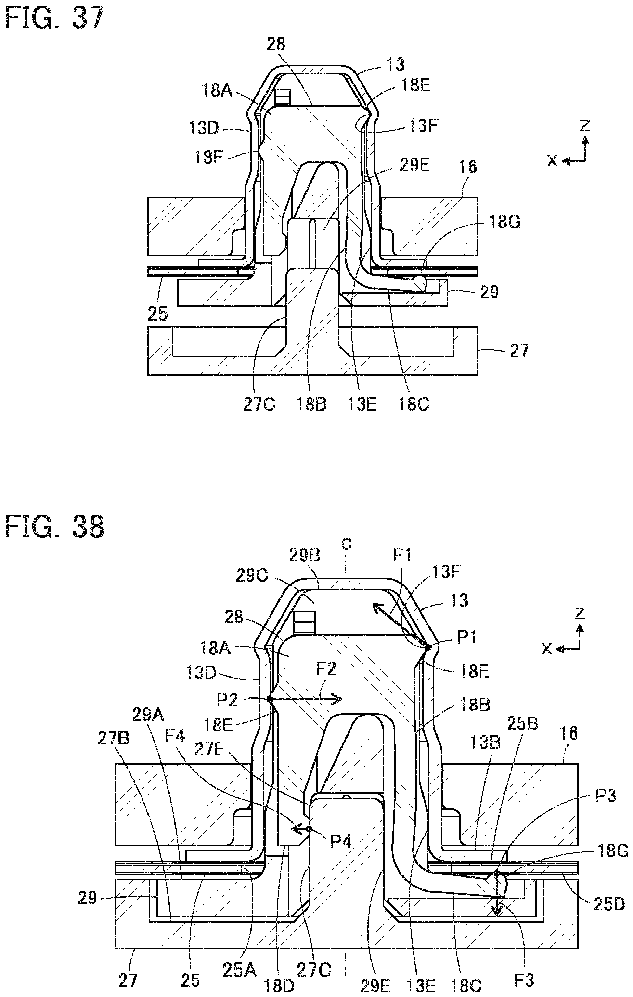

When the boss member 29 is further pressed in the +Z direction in this state, the flat plate portion 18A moves in the +Z direction while the first extending portion 18B and the arm portion 18C of the inner contact 28 are elastically deformed, and as shown in FIG. 37, the hook portion 18E is received by the receiving portion 13F formed at the recessed portion 13E of the plug contact 13.

Consequently, the inner contact 28 is rotated clockwise in FIG. 37 and retained by the plug contact 13 in a state where the protruding portion 18G of the arm portion 18C is pressed in the -Z direction from the sheet type conductive member 25 and elastically deformed, and the protruding portion 18F of the flat plate portion 18A is pressed in the -X direction from the inner surface of the small diameter portion 13D of the plug contact 13.

Here, by pressing the bottom insulator 27 toward the top insulator 16, each of the four protrusion portions 27C of the bottom insulator 27 is inserted into the protrusion portion accommodating hole 29E of the corresponding boss member 29 from the -Z direction.

In addition, by pressing the bottom insulator 27 against the top insulator 16, the bosses 16C of the top insulator 16 sequentially penetrate the through-holes 25F of the sheet type conductive member 25, and the through-holes 27D of the bottom insulator 27. Thereafter, the top insulator 16 and the bottom insulator 27 are fixed to each other through heat deformation of a tip of each of the plurality of bosses 16C projecting on the -Z direction side of the bottom insulator 27. Thus, the assembling operation of the connector 21 is completed.

In the connector 21 assembled as above, as shown in FIG. 38, the base portion 29A of the boss member 29 is accommodated in the contact arrangement region 27B of recess shape of the bottom insulator 27, the restriction portion 27E constituted of the lateral surface of the protrusion portion 27C of the bottom insulator 27 inserted in the protrusion portion accommodating hole 29E of the boss member 29 makes contact with the restricted portion P4 set at the -Z directional end portion of the second extending portion 18D of the inner contact 28 inserted in the inner contact accommodating groove 29C communicating with the protrusion portion accommodating hole 29E. Therefore, counterclockwise rotation of the inner contact 28 in FIG. 38 is restricted.

In addition, the flange 13B of the plug contact 13 is situated around the corresponding opening portion 25A of the sheet type conductive member 25, and the sheet type conductive member 25 is sandwiched between the protruding portion 18G formed at the -X directional end portion of the arm portion 18C of the inner contact 28 and the bottom surface on the -Z direction side of the flange 13B of the plug contact 13.

The inner contact 28 is retained in a state where the first contacting portion P1 set at the hook portion 18E of the flat plate portion 18A is receiving the force F1 acting in the +X direction and the +Z direction from the receiving portion 13F of the plug contact 13, the second contacting portion P2 set at the protruding portion 18F of the flat plate portion 18A is receiving the force F2 acting in the -X direction from the inner surface of the small diameter portion 13D of the plug contact 13, the third contacting portion P3 set at the protruding portion 18G of the arm portion 18C is receiving the force F3 acting in the -Z direction from the bottom surface of the sheet type conductive member 25 and is elastically displaced, and the restricted portion P4 set at the second extending portion 18D is receiving the force F4 acting in the +X direction from the restriction portion 27E of the protrusion portion 27C of the bottom insulator 27.

Thus, the first and second contacting portions P1 and P2 are pressed against and make contact with the inner surface of the recessed portion 13E of the plug contact 13, whereby the inner contact 28 is electrically connected to the plug contact 13.

In addition, the top surface on the +Z direction side of the sheet type conductive member 25 is pressed against the bottom surface of the flange 13B of the plug contact 13, while the bottom surface on the -Z direction side of the sheet type conductive member 25 is pressed against the third contacting portion P3 of the inner contact 28.

Here, as shown in FIGS. 31 and 32, on the top surface of the sheet type conductive member 25, the wiring layer 25B is exposed around the opening portions 25A, and on the bottom surface of the sheet type conductive member 25, the wiring layer 25D is exposed around the opening portions 25A.

Therefore, the wiring layer 25B on the top surface of the sheet type conductive member 25 makes contact with the bottom surface of the flange 13B of the plug contact 13 with predetermined contact pressure, while the wiring layer 25D on the bottom surface of the sheet type conductive member 25 makes contact with the third contacting portion P3 of the inner contact 28 with predetermined contact pressure.

Therefore, the wiring layer 25B exposed on the top surface of the sheet type conductive member 25 is electrically connected to the plug contact 13 directly, and the wiring layer 25D exposed on the bottom surface of the sheet type conductive member 25 is electrically connected to the plug contact 13 via the inner contact 28. In other words, both the wiring layers 25B and 25D are connected to the plug contact 13.

Thus, in the connector 21, as with the connector 11 of Embodiment 1, both the wiring layer 25B and the wiring layer 25D respectively formed of the conductor disposed on the top surface side and the conductor disposed on the bottom surface side of the sheet type conductive member 25 can be electrically connected to the single plug contact 13.

Therefore, when the connector 21 is connected to a sheet type conductive member having a conductor exposed only on its top surface side, the plug contact 13 can be electrically connected to the conductor on the top surface side of the sheet type conductive member. On the other hand, when the connector 21 is connected to a sheet type conductive member having a conductor exposed only on its bottom surface side, the plug contact 13 can be electrically connected to the conductor on the bottom surface side of the sheet type conductive member.

In addition, as with the connector 11 of Embodiment 1, the force F4 is applied from the restriction portion 27E of the protrusion portion 27C of the bottom insulator 27 to the restricted portion P4 of the inner contact 28, whereby the small-sized connector 21 can be achieved.

The tubular portion 13A of the plug contact 13 has a cylindrical shape extending along the fitting axis C, the projection 29B of the boss member 29 is formed to project on the center part of the base portion 29A of circular disk shape, the protrusion portion 27C of the bottom insulator 27 is formed to project on the center part of the contact arrangement region 27B of circular shape, and the wiring layers 25B, 25D of the sheet type conductive member 25 are respectively exposed on the top surface and the bottom surface of the sheet type conductive member 25 so as to surround the opening portions 25A.

Therefore, when the boss member 29 in which the inner contact 28 is retained by the projection 29B is pressed in the +Z direction toward the top insulator 16, even with the inner contact 28 facing in either of the rotational directions about the fitting axis C, the flat plate portion 18A, the first extending portion 18B, and the second extending portion 18D of the inner contact 28 are inserted into the recessed portion 13E of the plug contact 13, and further, the protrusion portion 27C of the bottom insulator 27 is inserted into the protrusion portion accommodating hole 29E of the boss member 29, so that the wiring layers 25B, 25D of the sheet type conducive member 25 can be electrically connected to the plug contact 13. Of the lateral surface along the outer periphery of the protrusion portion 27C of the bottom insulator 27, a part facing the restricted portion P4 of the inner contact 28 serves as the restriction portion 27E and applies the force F4 to the restricted portion P4.

While the plug contact 13 is connected to both the wiring layer 15B, 25B and the wiring layer 15D, 25D respectively exposed on the top surface side and the bottom surface side of the sheet type conductive member 15, 25 in Embodiments 1 and 2 above, only the wiring layer 15D, 25D exposed on the bottom surface side of the sheet type conductive member 15 may be connected to the plug contact 13, for instance.

While the sheet type conductive member 15, 25 used in Embodiments 1 and 2 above has a multilayer structure, the invention is not limited thereto, and it suffices if the sheet type conductive member has a conductor exposed on at least one surface thereof.

In addition, while the two layers of the conductors, i.e., the wiring layer 15B, 25B and the wiring layer 15D, 25D of the sheet type conductive member 15, 25 are connected to the single plug contact 13 in Embodiments 1 and 2 above, the invention is not limited thereto, and three or more layers of conductors may be connected to the single plug contact 13.

In addition, while the connector 11, 21 according to Embodiments 1 and 2 above has the four plug contacts 13, the invention is not limited to this number of the plug contacts 13, and it suffices if the connector includes at least a single plug contact 13 to be electrically connected to a conductor exposed on at least one surface of the sheet type conductive member 15, 25.

**Claims**

1. A connector comprising:

   a plug contact (13) having conductivity and including a tubular portion (13A) and a flange, the tubular portion extending along a fitting axis (C) and being provided in its interior with a recessed portion (13E), and the flange extending from a base end of the tubular portion in a direction orthogonal to the fitting axis;
   an inner contact (18, 28) having conductivity and being supported while having part of the inner contact inserted in the recessed portion; and
   a housing (12, 22) retaining the plug contact, wherein the housing includes a restriction portion (17H, 27E) that is disposed in the recessed portion of the plug contact and is configured to restrict rotation of the inner contact, the inner contact includes

   a first contacting portion (P1) that makes contact with an inner surface of the recessed portion to be electrically connected to the plug contact,
   a second contacting portion (P2) that makes contact with the inner surface of the recessed portion on an opposite side from the first contacting portion across the fitting axis and at a position closer to the base end of the recessed portion than the first contacting portion is,
   a third contacting portion (P3) extending in a direction orthogonal to the fitting axis and facing the flange, and
   a restricted portion (P4) that faces in an opposite direction from the second contacting portion and makes contact with the restriction portion at a position closer to the base end of the recessed portion than the second contacting portion is, and

part of a connection object (15, 25) of sheet shape having a conductor (15B, 15D, 25B, 25D) exposed on at least one surface of the connection object is sandwiched between a bottom surface of the flange of the plug contact and the third contacting portion of the inner contact in a direction along the fitting axis, the bottom surface of the flange makes contact with a top surface of the connection object, and the third contacting portion makes contact with a bottom surface of the connection object, whereby the plug contact is electrically connected to the conductor directly when the conductor is exposed on the top surface of the connection object, and the plug contact is electrically connected to the conductor via the inner contact when the conductor is exposed on the bottom surface of the connection object.

2. The connector according to claim 1,

   wherein the inner contact (18, 28) includes:

   a flat plate portion (18A) extending both in an axial direction along the fitting axis and an orthogonal direction orthogonal to the fitting axis across an inside of the recessed portion,
   a first extending portion (18B) extending along the fitting axis from one end of the flat plate portion in the orthogonal direction toward the base end of the recessed portion;
   an arm portion (18C) extending from a tip of the first extending portion in the orthogonal direction; and
   a second extending portion (18D) extending along the fitting axis from another end of the flat plate portion in the orthogonal direction toward the base end of the recessed portion,

   the first contacting portion (P1) is disposed at the one end of the flat plate portion in the orthogonal direction,
   the second contacting portion (P2) is disposed at the another end of the flat plate portion in the orthogonal direction,
   the third contacting portion (P3) is disposed at a tip of the arm portion, and
   the restricted portion (P4) is disposed on a lateral surface of the second extending portion, the lateral surface facing the first extending portion.

3. The connector according to claim 2,

   wherein the inner contact (18, 28) includes a hook portion (18E) projecting in the orthogonal direction from the one end of the flat plate portion, the first contacting portion being disposed at a tip of the hook portion, and
   the plug contact (13) includes a receiving portion (13F) formed inside the recessed portion and receiving the hook portion.

4. The connector according to any one of claims 1-3, wherein the third contacting portion (P3) makes contact with the bottom surface of the connection object while being elastically displaced.

5. The connector according to any one of claims 1-4,

   wherein the housing (12, 22) has a projection (17C, 29B) extending along the fitting axis and inserted into the recessed portion of the plug contact,
   the projection has an inner contact accommodating groove (17E, 29C) in which the inner contact is accommodated, and
   the restricting portion (17H, 27E) is disposed inside the inner contact accommodating groove.

6. The connector according to claim 5,

   wherein the housing (12) has a bottom insulator (17) provided with the projection, and
   the restriction portion (17H) is formed inside the inner contact accommodating groove (17E) of the projection.

7. The connector according to claim 5 or 6,

   wherein the inner contact (18) includes a press-fitting portion (18H) of convex shape that is formed to protrude from a surface of the flat plate portion in a direction orthogonal to the surface of the flat plate portion,
   the inner contact accommodating groove (17E) includes a first accommodating groove (17F) disposed at an opening end portion of the inner contact accommodating groove, and a second accommodating groove (17G) disposed at an inner part of the inner contact accommodating groove than the first accommodating groove and communicating with the first accommodating groove,
   the first accommodating groove (17F) has a first groove width (W2) that allows a part of the inner contact, at which part the press-fitting portion is formed, to be inserted into the first accommodating groove, and
   the second accommodating groove (17G) has a second groove width (W3) narrower than a thickness dimension (D2) of the inner contact at the part at which the press-fitting portion is formed.

8. The connector according to claim 5,

   wherein the housing (22) includes:

   a bottom insulator (27) provided with a boss accommodating portion (27C) of recess shape; and
   a boss member (29) accommodated in the boss accommodating portion and provided with the projection (29B),

   the bottom insulator includes a protrusion portion (27C) protruding from a bottom part of the boss accommodating portion along the fitting axis,
   the boss member (29) includes a protrusion portion accommodating hole (29E) communicating with the inner contact accommodating groove (29C) and accommodating the protrusion portion, and
   the restriction portion (27E) is formed by a lateral surface of the protrusion portion.

9. The connector according to claim 5 or 8, wherein the projection (29B) includes an abutment portion (29D) disposed at a bottom part of the inner contact accommodating groove (29C) and abutting the inner contact in a direction along the fitting axis.

10. The connector according to any one of claims 1-9, comprising a top insulator (16) provided with a contact through-hole (16B) that is penetrated by the tubular portion of the plug contact and is smaller than the flange.

**Patentansprüche**

1. Verbinder, umfassend:

   einen Steckkontakt (13), der Leitfähigkeit besitzt und einen rohrförmigen Abschnitt (13A) und einen Flansch aufweist, wobei sich der rohrförmige Abschnitt entlang einer Montageachse (C) erstreckt und in seinem Inneren mit einem zurückgesetzten Abschnitt (13E) versehen ist, und wobei sich der Flansch von einem Basisende des rohrförmigen Abschnitts in einer Richtung orthogonal zu der Montageachse erstreckt;
   einen inneren Kontakt (18, 28), der Leitfähigkeit besitzt und gestützt ist, während ein Teil des inneren Kontakts in den zurückgesetzten Abschnitt eingesetzt ist; und
   ein Gehäuse (12, 22), das den Steckkontakt hält,

wobei das Gehäuse einen Einschränkungsabschnitt (17H, 27E) aufweist, der in dem zurückgesetzten Abschnitt des Steckkontakts angeordnet ist und dazu eingerichtet ist, eine Drehung des inneren Kontakts einzuschränken, wobei der innere Kontakt aufweist:

einen ersten Kontaktierungsabschnitt (P1), der mit einer Innenfläche des zurückgesetzten Abschnitts Kontakt herstellt, um mit dem Steckkontakt elektrisch verbunden zu sein, einen zweiten Kontaktierungsabschnitt (P2), der mit der Innenfläche des zurückgesetzten Abschnitts an einer dem ersten Kontaktierungsabschnitt gegenüberliegenden Seite über die Montageachse hinweg und an einer Position, die näher an dem Basisende des zurückgesetzten Abschnitts liegt als der erste Kontaktierungsabschnitt, Kontakt herstellt, einen dritten Kontaktierungsabschnitt (P3), der sich in einer Richtung orthogonal zu der Montageachse erstreckt und dem Flansch zugewandt ist, und einen eingeschränkten Abschnitt (P4), der in eine dem zweiten Kontaktierungsabschnitt entgegengesetzte Richtung weist und mit dem Einschränkungsabschnitt an einer Position, die näher an dem Basisende des zurückgesetzten Abschnitts liegt als der zweite Kontaktierungsabschnitt, Kontakt herstellt, und

wobei ein Teil eines Verbindungsobjekts (15, 25) von einer Flachmaterialform, der einen Leiter (15B, 15D, 25B, 25D) aufweist, der an mindestens einer Fläche des Verbindungsobjekts frei liegt, zwischen einer Unterseite des Flansches des Steckkontakts und dem dritten Kontaktierungsabschnitt des inneren Kontakts in einer Richtung entlang der Montageachse sandwichartig aufgenommen ist, die Unterseite des Flansches mit einer Oberseite des Verbindungsobjekts Kontakt herstellt, und der dritte Kontaktierungsabschnitt mit einer Unterseite des Verbindungsobjekts Kontakt herstellt, wobei der Steckkontakt direkt mit dem Leiter elektrisch verbunden ist, wenn der Leiter an der Oberseite des Verbindungsobjekts frei liegt, und der Steckkontakt über den inneren Kontakt elektrisch mit dem Leiter verbunden ist, wenn der Leiter an der Unterseite des Verbindungsobjekts frei liegt.

2. Verbinder nach Anspruch 1,
wobei der innere Kontakt (18, 28) aufweist:

einen flachen Plattenabschnitt (18A), der sich sowohl in einer axialen Richtung entlang der Montageachse als auch einer orthogonalen Richtung orthogonal zu der Montageachse über eine Innenseite des zurückgesetzten Abschnitts hinweg erstreckt, einen ersten Erstreckungsabschnitt (18B), der sich entlang der Montageachse von einem Ende des flachen Plattenabschnitts in der orthogonalen Richtung zu dem Basisende des zurückgesetzten Abschnitts hin erstreckt; einen Armabschnitt (18C), der sich von einer Spitze des ersten Erstreckungsabschnitts in der orthogonalen Richtung erstreckt; und einen zweiten Erstreckungsabschnitt (18D), der sich entlang der Montageachse von einem anderen Ende des flachen Plattenabschnitts in der orthogonalen Richtung zu dem Basisende des zurückgesetzten Abschnitts hin erstreckt, wobei der erste Kontaktierungsabschnitt (P1) an dem einen Ende des flachen Plattenabschnitts in der orthogonalen Richtung angeordnet ist, der zweite Kontaktierungsabschnitt (P2) an dem anderen Ende des flachen Plattenabschnitts in der orthogonalen Richtung angeordnet ist, wobei der dritte Kontaktierungsabschnitt (P3) an einer Spitze des Armabschnitts angeordnet ist, und der eingeschränkte Abschnitt (P4) an einer Seitenfläche des zweiten Erstreckungsabschnitts angeordnet ist, wobei die Seitenfläche dem ersten Erstreckungsabschnitt zugewandt ist.

3. Verbinder nach Anspruch 2,

wobei der innere Kontakt (18, 28) einen Hakenabschnitt (18E) aufweist, der in der orthogonalen Richtung von dem einen Ende des flachen Plattenabschnitts vorsteht, wobei der erste Kontaktierungsabschnitt an einer Spitze des Hakenabschnitts angeordnet ist, und der Steckkontakt (13) einen Aufnahmeabschnitt (13F) aufweist, der im Inneren des zurückgesetzten Abschnitts gebildet ist und den Hakenabschnitt aufnimmt.

4. Verbinder nach einem der Ansprüche 1-3, wobei der dritte Kontaktierungsabschnitt (P3) mit der Unterseite des Verbindungsobjekts Kontakt herstellt, während er elastisch verlagert ist.

5. Verbinder nach einem der Ansprüche 1-4,

wobei das Gehäuse (12, 22) einen Vorsprung (17C, 29B) aufweist, der sich entlang der Montageachse erstreckt und in den zurückgesetzten Abschnitt des Steckkontakts eingesetzt ist,

der Vorsprung eine Aufnahmenut (17E, 29C) für den inneren Kontakt aufweist, in der der innere Kontakt aufgenommen ist, und

der Einschränkungsabschnitt (17H, 27E) im Inneren der Aufnahmenut für den inneren Kontakt gebildet ist.

6.  Verbinder nach Anspruch 5,

wobei das Gehäuse (12) einen unteren Isolator (17) aufweist, der mit dem Vorsprung versehen ist, und

der Einschränkungsabschnitt (17H) im Inneren der Aufnahmenut für den inneren Kontakt (17E) des Vorsprungs gebildet ist.

7.  Verbinder nach Anspruch 5 oder 6,

wobei der innere Kontakt (18) einen Presspassungsabschnitt (18H) von konvexer Form aufweist, der so gebildet ist, dass er von einer Fläche des flachen Plattenabschnitts in einer Richtung orthogonal zu der Fläche des flachen Plattenabschnitts vorsteht,

die Aufnahmenut (17E) für den inneren Kontakt eine erste Aufnahmenut (17F) aufweist, die an einem Öffnungsendabschnitt der Aufnahmenut für den inneren Kontakt angeordnet ist, und eine zweite Aufnahmenut (17G) aufweist, die an einem inneren Teil der Aufnahmenut für den inneren Kontakt angeordnet ist als die erste Aufnahmenut und mit der ersten Aufnahmenut in Verbindung steht,

die erste Aufnahmenut (17F) eine erste Nutbreite (W2) aufweist, die es erlaubt, einen Teil des inneren Kontakts, an dem der Presspassungsabschnitt gebildet ist, in die erste Aufnahmenut einzusetzen, und

die zweite Aufnahmenut (17G) eine zweite Nutbreite (W3) aufweist, die schmaler ist als eine Dickenabmessung (D2) des inneren Kontakts an dem Teil, an dem der Presspassungsabschnitt gebildet ist.

8.  Verbinder nach Anspruch 5,
    wobei das Gehäuse (22) aufweist:

einen unteren Isolator (27), der mit einem Pfostenaufnahmeabschnitt (27C) in Aussparungsform versehen ist; und

ein Pfostenelement (29), das in dem Pfostenaufnahmeabschnitt aufgenommen und mit dem Vorsprung (29B) versehen ist,

der untere Isolator einen Vorsprungsabschnitt (27C) aufweist, der von einem unteren Teil des Pfostenaufnahmeabschnitts entlang der Montageachse vorsteht,

das Pfostenelement (29) ein Vorsprungsabschnitt-Aufnahmeloch (29E) aufweist, das mit der Aufnahmenut (29C) für den inneren Kontakt in Verbindung steht und den Vorsprungsabschnitt aufnimmt, und

der Einschränkungsabschnitt (27E) von einer Seitenfläche des Vorsprungsabschnitts gebildet ist.

9.  Verbinder nach Anspruch 5 oder 8, wobei der Vorsprung (29B) einen Anliegeabschnitt (29D) aufweist, der an einem unteren Teil der Aufnahmenut (29C) für den inneren Kontakt angeordnet ist und an dem inneren Kontakt in einer Richtung entlang der Montageachse anliegt.

10. Verbinder nach einem der Ansprüche 1-9, umfassend einen oberen Isolator (16), der mit einem Kontaktdurchgangsloch (16B) versehen ist, durch das der rohrförmige Abschnitt des Steckkontakts hindurchgeführt ist und das kleiner als der Flansch ist.

## Revendications

1.  Connecteur comprenant :

un contact à fiche (13) présentant une conductivité et comportant une partie tubulaire (13A) et une bride, la partie tubulaire s'étendant le long d'un axe de montage (C) et étant pourvue dans son intérieur d'une partie évidée (13E), et la bride s'étendant à partir d'une extrémité de base de la partie tubulaire dans une direction orthogonale à l'axe de montage ;

un contact interne (18, 28) présentant une conductivité et étant supporté en ayant une partie du contact interne insérée dans la partie évidée ; et

un boîtier (12, 22) retenant le contact à fiche, dans lequel le boîtier comporte une partie de restriction (17H, 27E) qui est située dans la partie évidée du contact à fiche et qui est configurée pour restreindre la rotation du contact interne,

le contact interne comporte

une première partie de contact (P1) qui entre en contact avec une surface interne de la partie évidée pour être reliée électriquement au contact à fiche,

une deuxième partie de contact (P2) qui entre en contact avec la surface interne de la partie évidée sur un côté opposé à la première partie de contact à travers l'axe de montage et à une position plus proche de l'extrémité de base de la partie évidée que ne l'est la première partie de contact,

une troisième partie de contact (P3) s'étendant dans une direction orthogonale à l'axe de montage et faisant face à la bride, et une partie restreinte (P4) qui est orientée dans une direction opposée à la deuxième partie de contact et qui entre en contact avec la partie de restriction à une position plus proche de l'extrémité de base de la partie évidée que ne l'est la deuxième partie de contact, et

une partie d'un objet de connexion (15, 25) en forme de feuille possédant un conducteur (15B, 15D, 25B, 25D) exposé sur au moins une surface de l'objet de connexion est prise en sandwich entre une surface inférieure de la bride du contact à fiche et la troisième partie de contact du contact interne dans une direction le long de l'axe de montage, la surface inférieure de la bride entre en contact avec une surface supérieure de l'objet de connexion, et la troisième partie de contact entre en contact avec une surface inférieure de l'objet de connexion, moyennant quoi le contact à fiche est relié électriquement au conducteur directement lorsque le conducteur est exposé sur la surface supérieure de l'objet de connexion, et le contact à fiche est relié électriquement au conducteur par l'intermédiaire du contact interne lorsque le conducteur est exposé sur la surface inférieure de l'objet de connexion.

2. Connecteur selon la revendication 1,
dans lequel le contact interne (18, 28) comporte :

une partie plate (18A) s'étendant à la fois dans une direction axiale le long de l'axe de montage et dans une direction orthogonale à l'axe de montage à travers l'intérieur de la partie évidée, une première partie d'extension (18B) s'étendant le long de l'axe de montage à partir d'une extrémité de la partie plate dans la direction orthogonale vers l'extrémité de base de la partie évidée ; une partie de bras (18C) s'étendant à partir d'une pointe de la première partie d'extension dans la direction orthogonale ; et une seconde partie d'extension (18D) s'étendant le long de l'axe de montage à partir d'une autre extrémité de la partie plate dans la direction orthogonale vers l'extrémité de base de la partie évidée, la première partie de contact (P1) est située à l'une des extrémités de la partie plate dans la direction orthogonale, la deuxième partie de contact (P2) est située à l'autre extrémité de la partie plate dans la direction orthogonale, la troisième partie de contact (P3) est située à une pointe de la partie de bras, et
la partie restreinte (P4) est située sur une surface latérale de la seconde partie d'extension, la surface latérale faisant face à la première partie d'extension.

3. Connecteur selon la revendication 2,

dans lequel le contact interne (18, 28) comporte une partie crochet (18E) faisant saillie dans la direction orthogonale à partir de l'une extrémité de la partie plate, la première partie de contact étant située à une pointe de la partie crochet, et le contact à fiche (13) comporte une partie de réception (13F) formée à l'intérieur de la partie évidée et recevant la partie crochet.

4. Connecteur selon l'une quelconque des revendications 1 à 3, dans lequel la troisième partie de contact (P3) entre en contact avec la surface inférieure de l'objet de connexion lorsqu'elle est déplacée élastiquement.

5. Connecteur selon l'une quelconque des revendications 1 à 4,

dans lequel le boîtier (12, 22) possède une protubérance (17C, 29B) qui s'étend le long de l'axe de montage et qui est insérée dans la partie évidée du contact à fiche, la protubérance possède une rainure de logement de contact interne (17E, 29C) dans laquelle le contact interne est logé, et la partie de restriction (17H, 27E) est disposée à l'intérieur de la rainure de logement de contact interne.

6. Connecteur selon la revendication 5,

dans lequel le boîtier (12) possède un isolateur inférieur (17) pourvu de la protubérance, et la partie de restriction (17H) est formée à l'intérieur de la rainure de logement de contact interne (17E) de la protubérance.

7. Connecteur selon la revendication 5 ou 6,

dans lequel le contact interne (18) comporte une partie à ajustement forcé (18H) de forme convexe qui est formée pour faire saillie à partir d'une surface de la partie plate dans une direction orthogonale à la surface de la partie plate, la rainure de logement de contact interne (17E) comporte une première rainure de logement (17F) située au niveau d'une partie d'extrémité d'ouverture de la rainure de logement de contact interne, et une seconde rainure de logement (17G) située au niveau d'une partie intérieure de la rainure de logement de contact interne que la première rainure de logement et communiquant avec la première rainure de logement,

la première rainure de logement (17F) a une première largeur de rainure (W2) qui permet à une partie du contact interne, au niveau de laquelle la partie à ajustement forcé est formée, d'être insérée dans la première rainure de logement, et

la seconde rainure de logement (17G) a une seconde largeur de rainure (W3) plus étroite qu'une dimension d'épaisseur (D2) du contact interne au niveau de la partie où la partie à ajustement forcé est formée.

8.  Connecteur selon la revendication 5, dans lequel le boîtier (22) comporte :

un isolateur inférieur (27) pourvu d'une partie de logement de bossage (27C) en forme d'évidement ; et

un élément de bossage (29) logé dans la partie de logement de bossage et pourvu de la protubérance (29B),

l'isolateur inférieur comporte une partie saillante (27C) faisant saillie à partir d'une partie inférieure de la partie de logement de bossage le long de l'axe de montage, l'élément de bossage (29) comporte un trou de logement de partie saillante (29E) communiquant avec la rainure de logement de contact interne (29C) et logeant la partie saillante, et

la partie de restriction (27E) est formée par une surface latérale de la partie saillante.

9.  Connecteur selon la revendication 5 ou 8, dans lequel la protubérance (29B) comporte une partie de butée (29D) située au niveau d'une partie inférieure de la rainure de logement de contact interne (29C) et butant contre le contact interne dans une direction le long de l'axe de montage.

10. Connecteur selon l'une quelconque des revendications 1 à 9, comprenant un isolateur supérieur (16) pourvu d'un trou de passage de contact (16B) qui est pénétré par la partie tubulaire du contact à fiche et plus petit que la bride.

FIG. 1

FIG. 2

FIG. 3

16

16A

16B

16C

Z

X Y

FIG. 4

17B

17C

17

17A

17D

Z

X Y

FIG. 5

C

17E

17C

17B

Z

X Y

FIG. 6

17C    17E

X ← ⌐
      Y

A

A

17B

FIG. 7

17F    17C

17G

Z
↑→X

17E

17

17H    17B

FIG. 8

17C    17F

W2

Z
↑
Y ←

17G

W3

17E

W1

FIG. 9

FIG. 10

FIG. 11

FIG. 12

FIG. 13

FIG. 14

FIG. 15

FIG. 16

# FIG. 17

# FIG. 18

FIG. 19

FIG. 20

FIG. 21

FIG. 22

# FIG. 23

# FIG. 24

# FIG. 25

# FIG. 26

FIG. 27

FIG. 28

FIG. 29

FIG. 30

FIG. 31

# FIG. 32

25A
25
25D
25E
25F

Y
X
Z

# FIG. 33

18A
P1
18E
28
18F
18B
P2
P3
18G
18D
18C
P4

Z
X
Y

# FIG. 34

L21
P2
P1
18E
28
18F
18D
18B
P4
P3
18G
18C

Z
X

## FIG. 35

## FIG. 36

FIG. 37

FIG. 38

# FIG. 39
## PRIOR ART

FIG. 40
PRIOR ART

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018129244 A